Europäisches Patentamt

European Patent Office

Office européen des brevets

(11) Veröffentlichungsnummer: **0 117 525**
A2

(12) # EUROPÄISCHE PATENTANMELDUNG

(21) Anmeldenummer: **84101867.4**

(51) Int. Cl.³: **H 04 B 12/04**

(22) Anmeldetag: **22.02.84**

(30) Priorität: **23.02.83 DE 3306334**

(43) Veröffentlichungstag der Anmeldung: **05.09.84**
**Patentblatt 84/36**

(84) Benannte Vertragsstaaten: **AT BE CH DE FR GB IT LI NL SE**

(71) Anmelder: **SIEMENS AKTIENGESELLSCHAFT, Berlin und München Wittelsbacherplatz 2, D-8000 München 2 (DE)**

(72) Erfinder: **Grallert, Hans-Joachim, Dr., Tannenfleckstrasse 30, D-8038 Gröbenzell (DE)**

(54) Quantisierer für DPCM-Codierer.

(57) Quantisierer für DPCM-Codierer, der einen Lesespeicher (ROM) enthält, dem die zu quantisierenden DPCM-Signalwerte ($\Delta s$) ohne das Vorzeichenbit als Adressen zugeführt sind und dessen ausgelesene Codewörter (CW) die quantisierten DPCM-Signalwerte angeben. Durch den Quantisierer werden die DPCM-Signalwerte begrenzt damit auch die Anzahl der auszulesenden Codewörter (CW). Das Vorzeichenbit wird den ausgelesenen Codewörtern wieder zugeführt und ergänzt diese zu quantisierten DPCM-Signalwerten ($\Delta s_q$). Ausserdem erfolgt eine Rundung der Eingangswerte und der ausgelesenen Codewörter durch Fortlassen des jeweils niederwertigsten Bits.

## 5    Quantisierer für DPCM-Codierer

Die Erfindung betrifft einen Quantisierer für DPCM-Codierer mit einem Lesespeicher, dessen Adresseneingang die DPCM-Signalwerte zugeführt werden und an dessen Datenausgang als Codewörter die quantisierten DPCM-Signalwerte ausgelesen werden.

DPCM-Codierer werden zur Datenreduktion verwendet. Der Quantisierer ordnet hierbei jeweils mehreren an seinem Eingang anliegenden Codewörtern ein einziges Codewort zu, das - meist nach einer weiteren Codeumsetzung - ausgesendet wird. Der Quantisierer kann beispielsweise als logische Gatterschaltung aufgebaut sein. Ebenso kann ein Lesespeicher (ROM) als Quantisierer eingesetzt werden. Da jeder mögliche Eingangswert des Quantisierers eine Adresse für den Lesespeicher darstellt, ist der Speicherplatzbedarf beträchtlich.

Ausgehend von einem eingangs angegebenen Quantisierer, ist es die Aufgabe der Erfindung, einen Quantisierer mit geringem Speicherplatzbedarf anzugeben.

Diese Aufgabe wird erfindungsgemäß dadurch gelöst, daß dem Adresseneingang des Lesespeichers ein Begrenzer vorgeschaltet ist, dem die DPCM-Signalwerte ohne Vorzeichenbit zugeführt werden, daß das Vorzeichenbit jedes DPCM-Signalwertes mit dem zugehörigen ausgelesenen Codewort zum quantisierten DPCM-Signalwert zusammengefaßt wird und daß ab einem vorgegebenen Betrag der DPCM-Signalwerte stets dasselbe höchstwertige Codewort aus dem Lesespeicher ausgelesen wird.

0117525

Allein dadurch, daß dem Quantisierer das Vorzeichenbit
nicht zugeführt wird, wird der notwendige Speicherplatzbedarf halbiert. Durch die Begrenzung der Adressen auf
einen Maximalwert erfolgt eine weitere Reduzierung. Bereits bei der Begrenzung auf den halben Maximalwert erfolgt nochmals eine Halbierung der Anzahl benötigter Codewörter. Da auch die ausgegebenen Codewörter einen
kleineren Wertebereich umfassen, ergibt sich hier nochmals
die Einsparung eines oder auch mehrerer Bits je Codewort. Die Begrenzung der Eingangsadressen auf einen
Maximalwert hat im allgemeinen keine Nachteile, da ohnehin
bandbegrenzte Signale verarbeitet oder weiterverwendet
werden.

Es ist vorteilhaft, daß mindestens das niederwertigste
Bit jedes DPCM-Signalwertes dem Begrenzer nicht zugeführt und der Adressenumfang des Lesespeichers hierdurch
verringert wird.

Durch das Weglassen des niederwertigsten Bits oder
mehrerer niederwertiger Bits ergibt sich je weggelassenem Bit eine weitere Halbierung des Adressenbereichs.
Bei geschickter Wahl der Quantisierungsbereiche bleibt
die Genauigkeit des Quantisierers erhalten.

Es ist vorteilhaft, daß mindestens jeweils das niederwertigste Bit jedes quantisierten DPCM-Signalwertes
nicht im Lesespeicher abgespeichert ist und daß die ausgelesenen Codewörter durch Hinzufügen von niederwertigen
Bits ergänzt werden.

Durch die Rundung der ausgelesenen Werte des Quantisierers
kann der Speicherplatzbedarf nochmals reduziert werden.
Hierbei muß natürlich die erforderte Genauigkeit beachtet werden. Bei günstig gelegenen Quantisierungsgrenzen können die niederwertigsten Bits durch konstante
Werte ersetzt werden.

Weitere vorteilhafte Ausbildungen sind in den übrigen
Unteransprüchen angegeben.


Ein Ausführungsbeispiel der Erfindung wird anhand der
Figuren 1 bis 4 näher erläutert.


Es zeigen
Fig.  1  einen bekannten DPCM-Codierer,
Fig.  2  einen erfindungsgemäßen Quantisierer,
Fig.  3  einen umschaltbaren Quantisierer,
Fig.  4  einen mit einem einzigen Lesespeicher realisierten
         umschaltbaren Quantisierer,
Fig.  5  einen Begrenzer.

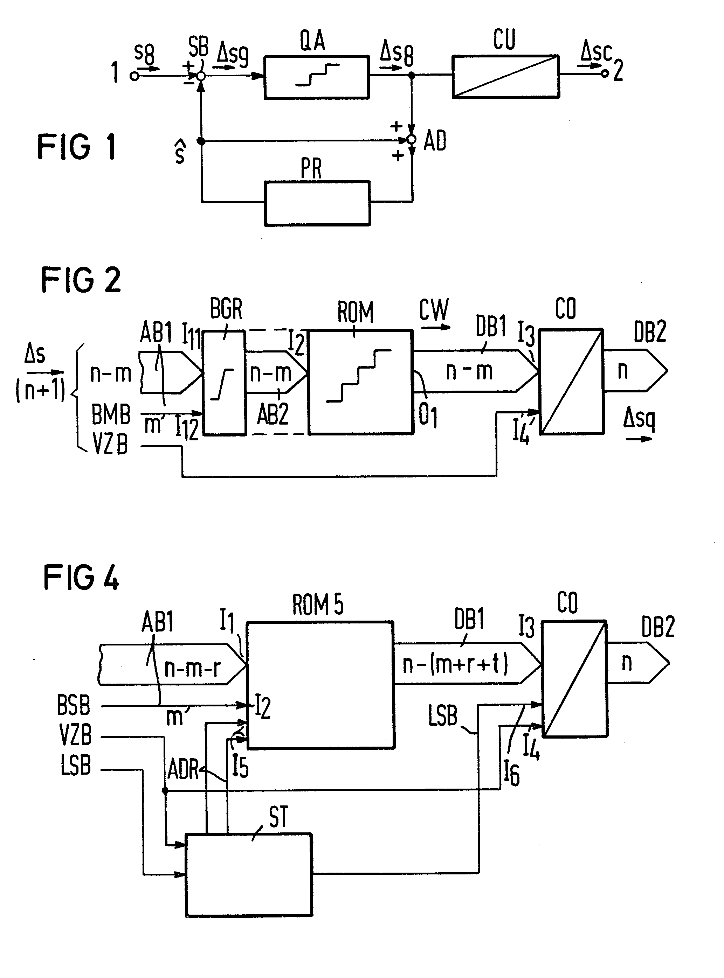

In Fig. 1 ist das Prinzipschaltbild eines DPCM-Codierers
dargestellt. Dem DPCM-Codierer werden an seinem Eingang 1
digitalisierte Abtastwerte zugeführt. Der Eingang 1  ist
mit einem ersten Eingang eines Subtrahierers SB verbunden,
dessen Ausgang an die Adresseneingänge eines Quantisierers
QA  angeschlossen ist. Der Ausgang des Quantisierers QA
ist mit einem Codeumsetzer CU verbunden, dessen Ausgang
mit 2 bezeichnet ist.Außerdem ist der Ausgang des Quantisierers QA  mit einem ersten Eingang eines Addierers AD
verbunden, dessen Ausgang mit dem Eingang eines Prädiktors
PR verbunden ist. In dem Prädiktor PR erfolgt im einfachsten
Fall eine Multiplikation mit einem konstanten Faktor.
Der Ausgang des Prädiktors ist mit einem zweiten Eingang
des Addierers AD und mit dem Subtraktionseingang des Subtrahierers SB verbunden.


Ein DPCM-Codierer setzt eine Folge von Abtastwerten $s_g$ in
eine Folge von quantisierten DPCM-Signalwerten $\Delta s_g$ um,
die jeweils aus einem berechneten Schätzwert $\hat{s}$ und dem Abtastwert ermittelt werden. Der Quantisierer QA  hat hierbei die Aufgabe, jeweils einem Bereich von Eingangswerten -
diese werden als Adressen verwendet - einen einzigen
Ausgangswert zuzuordnen.

Beispielsweise werden 512 Adressen nur 16 verschiedene Ausgangswerte $\Delta s_8$ zugeordnet. In diesem Beispiel wird davon ausgegangen, daß aus dem Lesespeicher ROM Codewörter mit 8 Bits Breite ausgelesen werden. Hier stellt das höchstwertigste Bit das Vorzeichen dar. Durch Verknüpfung des Schätzwertes mit dem aktuellen Abtastwert kann sich eine Wortbreite von 9 Bits ergeben. Diese 9 Bits $\Delta s_9$ werden dem Lesespeicher als Adresse zugeführt. Der Speicherplatzbedarf bei diesem einfachen Codierer beträgt demnach bereits $2^9 \cdot 8$ Bits.

Anstelle eines Lesespeichers (Read-Only-Memory) können auch andere Speichertypen verwendet werden.

Bei aufwendigen oder umschaltbaren Quantisierern wird der Speicherbedarf nochmals beträchtlich erhöht. Der dem Lesespeicher nachgeschaltete Codeumsetzer CU setzt die beispielsweise 16 möglichen Ausgangskombinationen des Lesespeichers in 4 Bits breite Codewörter ($\Delta sc$) um. Der Codeumsetzer kann sowohl als Logikschaltung als auch als Lesespeicher realisiert werden.

In Fig. 2 ist ein erfindungsgemäßer Quantisierer dargestellt. Er enthält einen Lesespeicher ROM, dessen Adressenbus mit AB2 und dessen Datenbus mit DB1 bezeichnet ist. Der Adresseneingang ist mit $I_2$, der Datenausgang mit $O_1$ bezeichnet.

Dem Lesespeicher ROM ist ein Begrenzer BGR vorgeschaltet, dem über seinen Adressenbus AB1 der Zahlenwert der DPCM-Signalwerte $\Delta s$ zugeführt wird und der eine begrenzte Adresse über den Adressenbus AB2 an den Lesespeicher ROM abgibt. Der Adressenbus AB1 umfaßt n Bits, während dem Quantisierer insgesamt n+1 Bits zugeführt werden. Das Vorzeichenbit VZB wird am Begrenzer BGR und am Lesespeicher ROM vorbeigeführt und gelangt an einen Eingang $I_4$ eines Codierers CO, dessen Eingang $I_3$ mit dem Datenbus DB1 verbunden ist. Über einen weiteren Datenbus DB2 werden vom Codierer die quantisierten Differenzsignale

abgegeben. Der Adressenbus AB1 ist zeichnerisch in einen niederwertigeren Teil, der an einen ersten Eingang $I_{11}$ des Begrenzers BGR angeschlossen ist, und in einem höherwertigerem Teil, der an einen zweiten Eingang $I_{12}$ des Begrenzers BGR angeschlossen ist, aufgeteilt. Diese Aufteilung soll die Begrenzung auf $2^{(n-m)}$ Adressen symbolisieren.

Innerhalb des DPCM-Codierers wird häufig mit dem Zweierkomplementcode wegen Vorteilen der Addition und Subtration gerechnet. Dieser Code ist in der folgenden Tabelle für n = 8 dargestellt.

| | VZB | BSB | | LSB | CU |
|---|---|---|---|---|---|
| - 255 | 1 | 0 | 000 000 | 1 | |
| ⋮ | | | ⋮ | | |
| - 127 | 1 | 1 | 000 000 | 1 | 1111 |
| - 126 | 1 | 1 | 000 001 | 0 | 1110 |
| - 125 | 1 | 1 | 000 001 | 1 | 1110 |
| ⋮ | | | ⋮ | | |
| - 1 | 1 | 1 | 111 111 | 1 | 1000 |
| 0 | 0 | 0 | 000 000 | 0 | 0000 |
| + 1 | 0 | 0 | 000 000 | 1 | 0000 |
| + 2 | 0 | 0 | 000 001 | 0 | 0000 |
| + 3 | 0 | 0 | 000 001 | 1 | 0000 |
| + 4 | 0 | 0 | 000 010 | 0 | 0001 |
| ⋮ | | | ⋮ | | |
| + 7 | 0 | 0 | 000 011 | 1 | 0001 |
| + 8 | 0 | 0 | 000 100 | 0 | 0001 |
| ⋮ | | | ⋮ | | |
| + 127 | 0 | 0 | 111 111 | 1 | 0111 |
| + 128 | 0 | 1 | 000 000 | 0 | |
| ⋮ | | | ⋮ | | |
| + 255 | 0 | 1 | 111 111 | 1 | |

$$\underbrace{\qquad\qquad}_{n}$$

0117525

VPA 83 P 1094 E

Dem Lesespeicher ROM darf natürlich dieser Zweierkomplementcode nicht als Adresse zugeführt werden. Für gleiche positive und gleiche negative Werte muß stets dieselbe Adressenkombination anliegen, wie dies beispielsweise einer dualen Codierung der Werte 0 bis 255 gegeben ist. Bei diesem Beispiel wird davon ausgegangen, daß dem Begrenzer BGR dual codierte Adressen (DPCM-Signalwerten) zugeführt werden.

Durch Kombination mit dem Vorzeichenbit ergibt sich dann bei den ausgelesenen Codewörtern CW eine Verdoppelung des Wertebereichs. Als Adresse werden dem Lesespeicher nur n-m Bits zugeführt. Die übrigen m höchstwertigen Bits bewirken keine weitere Vergrößerung der ausgelesenen Codewörter. Beispielsweise soll eine Begrenzung der Eingangswerte bereits ab dem Wert 127 erfolgen. Geht man von $n = 8$ aus, bedeutet dies, daß das nach dem Vorzeichenbit VZB höchstwertige Bit BSB stets ab dem Zahlenwert 128 den Zustand der logischen Eins annimmt. Das heißt, wenn das Bit BSB die logische Eins hat, werden alle niederwertigeren Bits ebenfalls die logische Eins gesetzt, dies entspricht dem Zahlenwert 127 als höchstwertigem Codewort.

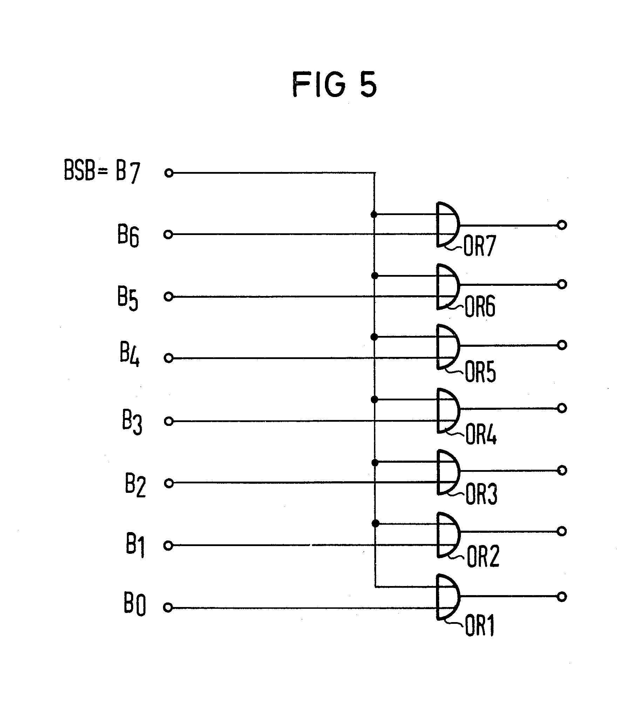

Ein solcher Begrenzer ist denkbar einfach (Fig. 5). Er besteht aus sieben ODER-Gattern (OR1 bis OR7), über die jewils ein Adressenbit $B_0$ bis $B_6$ geführt wird. An allen zweiten Eingängen der ODER-Gatter liegt das Bit BSB = $B_7$ an und setzt alle ODER-Gatter-Ausgänge auf die logische Eins, sobald der Schwellwert von 127 überschritten wird. Voraussetzung für einen solchen Begrenzeraufbau ist die Verwendung eines Vorzeichencodes, bei dem sich negative von betragsmäßig gleichen positiven Zahlen nur durch das Vorzeichenbit unterscheiden. Die Realisierung von Begrenzern für den Zweierkomplementcode ist ebenfalls für den Fachmann kein Problem. Der Begrenzer wird zweckmäßigerweise, wie in Fig. 2 angedeutet, in den Lesespeicher ROM integriert. Durch die Begrenzung auf einen maximalen Wert der Adresse wird einmal die Anzahl der Codewörter reduziert, zum anderen werden weniger Bits zur Darstellung der den Adressenwerten entsprechenden Codewörtern benötigt. Die Breite des Datenbusses DB1 ist entsprechend reduziert. Der Codierer CO versieht die vom Lesespeicher ROM ausgegebenen Codewörter wieder mit einem Vorzeichenbit. Er kann zusätzlich durch eine Umwandlung

P 1 Seu / 17.11.83

in den Zweierkomplementcode vornehmen. Außerdem werden die höherwertigen Bits ergänzt, um einen Datenbus mit der in der DPCM-Schleife verwendeten Breite zu erhalten.

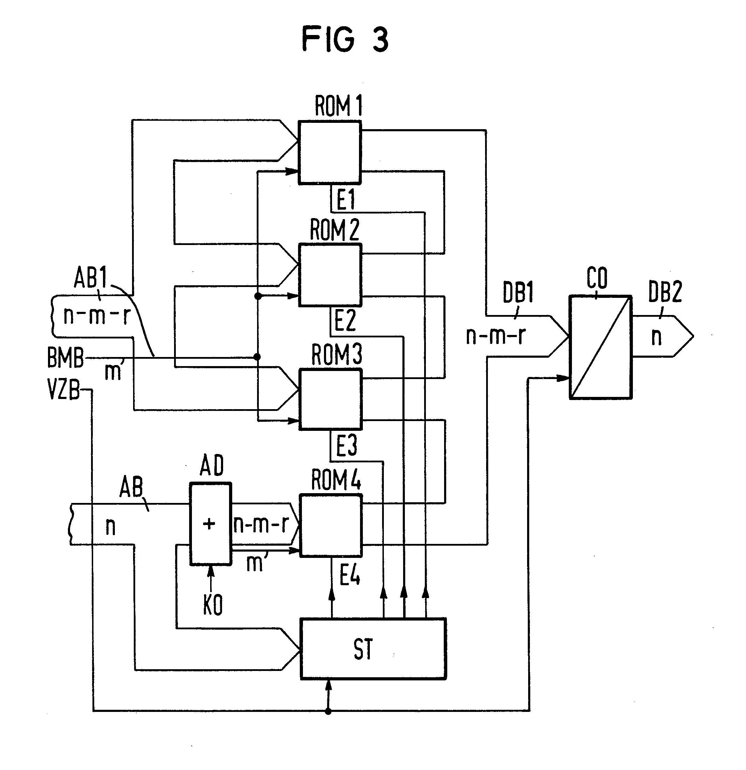

In Fig. 3 ist ein umschaltbarer Quantisierer dargestellt. Er enthält vier Lesespeicher ROM1 bis ROM4, die eingangsseitig über den Adressenbus AB1 und ausgangsseitig über 3-State-Ausgänge über den Datenbus DB1 zusammengeschaltet sind. Außerdem werden allen Lesespeichern bzw. deren integrierten Begrenzern, gleichzeitig die betragsmäßig höchstwertigen Bits BMB zugeführt. Von einer Steuerung ST wird jeweils ein Lesespeicher ROM1 bis ROM4 über Aktivierungseingänge E1 bis E4 aktiv geschaltet. Durch die Auswahl der verschiedenen Lesespeicher werden unterschiedliche Quantisierungskennlinien realisiert. Die Auswahl erfolgt von der Steuerung, die nicht zur Erfindung gehört durch ständiges Überprüfen der Leseadressen, das heißt also der Amplituden der anliegenden Nachricht.

Beispielsweise erfolgt eine unterschiedliche Quantisierung in Abhängigkeit von der Differenz zwischen aufeinanderfolgender Signalamplituden. Die Steuerung besteht dann im wesentlichen aus einem Subtrahierer, dem z.B. zwei aufeinanderfolgende Signalwerte zugeführt werden. Der Betrag der Differenz, es reicht im allgemeinen aus, nur die höchstwertigen Bits zu berücksichtigen, bestimmt dann die Quantisierung.
Den Adresseneingängen des vierten Lesespeichers ROM4 ist ein Addierer AD vorgeschaltet. Der Datenbus DB1 und das Vorzeichenbit sind wieder dem Codierer CO zugeführt.

Wie schon erwähnt, können bei diesem Quantisierer durch die Ansteuerung verschiedener Lesespeicher verschiedene Quantisierungskennlinien realisiert werden. Eine weitere Einsparung an Speicherplätzen wird erreicht, indem die

P 1 Seu / 17.11.83

DPCM-Signalwerte $\Delta s$, d.h. die Adressen, gerundet werden, zum Beispiel durch Fortlassen des niederwertigsten Bits oder von r niederwertigsten Bits.

Dem Addierer AD, der dem Lesespeicher ROM4 vorgeschaltet ist, wird die komplette Eingangsadresse über einen Datenbus AB zugeführt. Zu der Adresse wird ein konstanter Wert addiert. Vom Ausgang des Addierers werden dem Adresseneingang des vierten Lesespeichers ROM4 wieder dieselben Bits zugeführt wie dem übrigen Lesespeicher.

P 1 Seu / 17.11.83

Die Addition bewirkt, daß trotz Rundung der Adressenwerte die Grenzen der Quantisierungsbereiche verschoben werden können. Im Codierer CO erfolgt wieder die Ergänzung der ausgelesenen Signalwerte zu einem Datenbus DB2 der benötigten Breite.

In Fig. 4 ist die Realisierung eines umschaltbaren Quantisierers mit nur einem Lesespeicher ROM5 dargestellt. Die Darstellung entspricht im wesentlichen dem Quantisierer nach Fig. 1. Der Lesespeicher ROM5 weist jedoch einen zusätzlichen Eingang I5 auf, über den die Steuerung ST eingreift. Dies geschieht durch zwei Adreß-Steuerleitungen ADR, mit denen vier verschiedene Adressenbereiche des Lesespeichers eingestellt werden. Zusätzlich werden noch die ausgelesenen Codewörter durch Weglassen von t niederwertigsten Bits gerundet, so daß ein ausgelesenes Codewort $n-(m+r+t)$ Bits umfaßt. ($m$ = Anzahl der nicht zur Adressierung verwendeten höchstwertigen Bits, $r$ = Anzahl der durch Rundung der Adresse eingesparten Bits, $t$ = Anzahl der durch Rundung der ausgelesenen Codewörter eingesparten Bits.)

Für die weiteren Berechnungen in der DPCM-Schleife werden die ausgelesenen Codewörter wieder durch Hinzufügen der t niederwertigsten Bits auf die notwendige Anzahl von Bits ergänzt. Die Ergänzung kann durch feste logische Werte oder auch von der Steuerung entsprechend den gewählten Quantisierungen erfolgen.

Ein kurzes Berechnungsbeispiel soll die Einsparungsmöglichkeit nochmals sichtbar machen. Ursprünglich waren beispielsweise $2^9 \cdot 8$ Bits Speicherplätze notwendig. Durch Fortlassen des Vorzeichens und Begrenzung der maximalen Adresse auf 127 statt ursprünglich $\pm$ 255 sind noch $2^7 \cdot 7$ Bits erforderlich. Durch Rundung der Adresse um nur ein Bit und Rundung der ausgelesenen Codewörter um ein Bit sind noch $2^6 \cdot 6$ Bits an Speicherplätzen in einem Lesespeicher erforderlich. Bei diesem Beispiel bedeutet das eine Reduzierung des Speicherplatz auf ca. 1/10 des ursprünglichen Speicherplatzbedarfs.

10 Patentansprüche
4 Figuren

0117525

## Patentansprüche

1. Quantisierer (QA) für DPCM-Codierer mit einem Lesespeicher (ROM), dessen Adresseneingang ($I_2$) die DPCM-Signalwerte zugeführt werden und an dessen Datenausgang als Codewörter die quantisierten DPCM-Signalwerte ($\Delta s_9$) ausgelesen werden, d a d u r c h  g e k e n n z e i c h - n e t , daß dem Adresseneingang ($I_2$) des Lesespeichers (ROM) ein Begrenzer (BGR) vorgeschaltet ist, dem die DPCM-Signalwerte ($\Delta s$) ohne Vorzeichenbit (VZB) zugeführt werden, daß das Vorzeichenbit (VZB) jedes DPCM-Signalwertes ($\Delta s$) mit dem zugehörigen ausgelesenen Codewort (CW) zum quantisierten DPCM-Signalwerte ($\Delta s_9$) zusammengefaßt wird und daß ab einem vorgegebenen Betrag der DPCM-Signalwerte ($\Delta s$) stets dasselbe höchstwertige Codewort (CW) aus dem Lesespeicher (ROM) ausgelesen wird.

2. Quantisierer nach Anspruch 1 , d a d u r c h  g e - k e n n z e i c h n e t , daß mindestens das niederwertigste Bit (LSB) jedes DPCM-Signalwertes ($\Delta s$) dem Begrenzer (BGR) nicht zugeführt und der Adressenumfang des Lesespeichers (ROM) hierdurch verringert wird.

3. Quantisierer nach Anspruch 1 oder 2, d a d u r c h  g e k e n n z e i c h n e t , daß mindestens jeweils das niederwertigste Bit (LSB) jedes quantisierten DPCM-Signalwertes ($\Delta s_9$) nicht im Lesespeicher (ROM) abgespeichert ist und daß die ausgelesenen Codewörter durch Hinzufügen von niederwertigen Bits ergänzt werden.

4. Quantisierer nach einem der vorhergehenden Ansprüche, d a d u r c h  g e k e n n z e i c h n e t , daß der Begrenzer (BGR) in den Lesespeicher (ROM) integriert ist.

5. Quantisierer nach einem der vorhergehenden Ansprüche, d a d u r c h  g e k e n n z e i c h n e t , daß der Quantisierer (QA) mehrere Lesespeicher (ROM1 bis ROM4) mit unterschiedlichen Quantisierungskennlinien enthält, von denen jeweils ein Lesespeicher (ROM1 bis ROM4) von einer Steuerung aktiviert wird.

6. Quantisierer nach Anspruch 5, d a d u r c h  g e - k e n n z e i c h n e t , daß ein Quantisierer mit unterschiedlichen Quantisierungskennlinien in einem einzigen Lesespeicher (ROM) realisiert ist, dessen Speicherbereiche über zusätzliche Adresseneingänge ($I_5$) umschaltbar sind.

7. Quantisierer nach einem der vorhergehenden Ansprüche, d a d u r c h  g e k e n n z e i c h n e t , daß dem Begrenzer (BGR) ein Addierer (AD) vorgeschaltet ist, der zu den vom Vorzeichenbit (VZB) befreiten DPCM-Signalwerten ($\Delta$s) einen konstanten Betrag addiert.

8. Quantisierer nach einem der vorhergehenden Ansprüche, d a d u r c h  g e k e n n z e i c h n e t , daß der Adresseneingang ($I_2$) des Lesespeichers (ROM) unter Fortlassung des niederwertigsten Bits sechs Bits umfaßt und daß die gespeicherten Codewörter unter Fortlassung des niederwertigsten Bits jeweils sechs Bits umfassen.

9. Quantisierer nach einem der vorhergehenden Ansprüche, d a d u r c h  g e k e n n z e i c h n e t , daß dem Lesespeicher (ROM; ROM1 bis ROM4) ein Codierer (CO) nachgeschaltet ist, dem die ausgelesenen Codewörter, das Vorzeichenbit und gegebenenfalls die nichtgespeicherten niederwertigsten Bits zugeführt sind, der die ausgelesenen Codewörter in den Zweierkomplementcode umsetzt.

10. Quantisierer nach einem der vorhergehenden Ansprüche, d a d u r c h   g e k e n n z e i c h n e t , daß die gesamte Schaltungsanordnung als integrierter Baustein ausgeführt ist.

0117525

**FIG 1**

**FIG 2**

**FIG 4**

## FIG 3

0117525

# FIG 5